# EUROPEAN PATENT APPLICATION

(11) **EP 4 665 116 A2**
(43) Date of publication of application: **17.12.2025**
(21) Application number: 25212527.3
(22) Date of filing: 30.10.2025
(51) Int. Cl.: H10F 19/90, H10F 77/20, H10F 77/00

(54) **PHOTOVOLTAIC MODULE**

(30) Priority: 23.01.2025 CN 202510112226
(71) Applicant: Jinko Solar (Haining) Co., Ltd., Haining City, Zhejiang 314415 (CN)
(72) Inventor: TAO, Wusong, Haining City, Zhejiang, 314415 (CN); WANG, Luchuang, Haining City, Zhejiang, 314415 (CN); CHEN, Zhendong, Haining City, Zhejiang, 314415 (CN); ZHOU, Yunfeng, Haining City, Zhejiang, 314415 (CN)
(74) Representative: Ipsilon

(57) **Abstract**

The present application provides a photovoltaic module, including: a first cell piece and a second cell piece each having a front face and a back face opposite to each other and each provided with an electrode thereon; a busbar at least partially disposed on the back faces of the first and second cell pieces; an insulating layer disposed at least between the back face of the first cell piece and the busbar; and a first solder ribbon and a second solder ribbon. The first solder ribbon is disposed to bend from the front face to the back face of the first cell piece to be electrically connected between the electrode on the front face of the first cell piece and the busbar. The second solder ribbon is separately electrically connected to the electrode on the back face of the second cell piece and the busbar.

## Description

### TECHNICAL FIELD

The present application relates to the field of manufacturing technology for solar cells, and in particular to a photovoltaic module.

### BACKGROUND

As an emerging energy source, solar energy offers several advantages over conventional fossil fuels, including being inexhaustible, clean, and environmentally friendly. Currently, one of primary methods for utilizing the solar energy is through a solar cell assembly, which converts received light energy into electrical energy for output. The solar cell assembly can be a large-area cell assembly formed by a plurality of solar cells (also known as photovoltaic cells or photovoltaic modules) that are connected in series, encapsulated, and arranged in an array. The solar cells absorb light energy, resulting in the accumulation of charges of opposite polarities at two ends of the cell, thereby generating a "photovoltaic voltage", which is known as the "photovoltaic effect." Due to the photovoltaic effect, electrodynamic potentials are generated at the two ends of the solar cell, thereby converting the light energy into the electrical energy. In the photovoltaic modules, solder ribbons and busbars are used to conduct the current collected by the cell pieces into a junction box. As current lead-out lines in the solar modules, the busbars play a crucial role.

However, in the related art, the busbar is disposed between two adjacent cell pieces, meaning that the busbar and the cell pieces are placed in the same plane. Since the busbar occupies a portion of the area of the photovoltaic module, the effective area of the photovoltaic module for receiving sunlight is reduced, decreasing the area utilization rate and module power of the photovoltaic module.

### SUMMARY

In view of above, there is a need to provide a photovoltaic module to address the problem that placing the busbars and the cell pieces in the same plane reduces the area utilization rate and module power of the photovoltaic module.

The present application provides a photovoltaic module, including:
a first cell piece and a second cell piece arranged in a first direction, the first cell piece and the second cell piece each having a front face and a back face opposite to each other, and the front face and the back face of each of the first cell piece and the second cell piece being each provided with an electrode thereon;
a busbar at least partially disposed on the back faces of the first cell piece and the second cell piece;
an insulating layer disposed at least between the back face of the first cell piece and the busbar; and
a first solder ribbon and a second solder ribbon;
wherein the first solder ribbon is disposed to bend from the front face of the first cell piece to the back face of the first cell piece, so as to be electrically connected between the electrode on the front face of the first cell piece and the busbar; and
the second solder ribbon is separately electrically connected to the electrode on the back face of the second cell piece and the busbar.

In some embodiments, the first solder ribbon includes a first connecting segment, a first curved segment, and a second connecting segment which are connected sequentially; the first connecting segment is disposed on a side of the front face of the first cell piece facing away from the back face of the first cell piece; the second connecting segment is disposed on a side of the back face of the first cell piece facing away from the front face of the first cell piece, and the first curved segment is disposed to bend in an arc shape.

In some embodiments, a surface of the busbar proximate to the second cell piece is connected to the electrode on the back face of the second cell piece through the second solder ribbon.

In some embodiments, the insulating layer includes a first insulating portion and a second insulating portion; the first insulating portion is disposed between the back face of the first cell piece and the busbar; and the second insulating portion is disposed between the back face of the second sell piece and the busbar.

The second solder ribbon is disposed to bend from a side of the second insulating portion proximate to the second cell piece to a side of the second insulating portion away from the second cell piece, so as to be electrically connected to each of the electrode on the back face of the second cell piece and the busbar.

In some embodiments, the second solder ribbon includes a third connecting segment, a second curved segment, and a fourth connecting segment which are sequentially connected; the third connecting segment is disposed between the back face of the second cell piece and the second insulating portion; the fourth connecting segment is disposed on the side of the second insulating portion away from the second cell piece; and the second curved segment is disposed to bend in an arc shape.

The first curved segment and the second curved segment are located on the same side of the busbar in a direction parallel to a plane where the first cell piece is located.

In some embodiments, the second connecting segment and the fourth connecting segment are disposed on the same side of the busbar in a direction parallel to a thickness direction of the first cell piece.

In some embodiments, the second connecting segment is disposed on a side of the busbar facing away from the first insulating portion, and the fourth connecting segment is disposed on a side of the busbar facing away from the second insulating portion.

Alternatively, the second connecting segment is disposed between the busbar and the first insulating portion, and the fourth connecting segment is disposed between the busbar and the second insulating portion.

In some embodiments, the second connecting segment and the fourth connecting segment are disposed on different sides of the busbar in a direction parallel to a thickness direction of the first cell piece.

In some embodiments, the second connecting segment is disposed on a side of the busbar facing away from the first insulating portion, and the fourth connecting segment is disposed between the busbar and the second insulating portion.

Alternatively, the second connecting segment is disposed between the busbar and the first insulating portion, and the fourth connecting segment is disposed on a side of the busbar facing away from the second insulating portion.

In some embodiments, the first connecting segment and the second connecting segment are spaced apart in the first direction, with a spacing between the first connecting segment and the second connecting segment in the first direction ranging from 0.5 millimeters to 3 millimeters.

In addition or alternatively, the first curved segment is spaced apart from a side edge of the first cell piece in a second direction perpendicular to the first direction and parallel to a plane where the first cell piece is located, with a spacing between the first curved segment and the side edge of the first cell piece in the second direction ranging from 0.3 millimeters to 2 millimeters.

In the embodiments of the present application, the busbar is disposed at least partially on the back faces of the first cell piece and the second cell piece. The first solder ribbon is disposed to bend from the front face of the first cell piece to the back face of the first cell piece, so as to be electrically connected between the electrode on the front face of the first cell piece and the busbar. Compared to the related art where the busbar and the cell pieces are placed in the same plane, in the present application, disposing the busbar at least partially on the back face of the cell string reduces the area occupied by the busbar within the photovoltaic module and increases the area of the photovoltaic module that receive the sunlight irradiation, thereby increasing the effective power generation area and improving both the area utilization rate and the module power of the photovoltaic module.

### BRIEF DESCRIPTION OF THE DRAWINGS

FIG. 1 is a first schematic perspective view of a photovoltaic module according to some embodiments of the present application.
FIG. 2 is a first schematic side view of a photovoltaic module according to some embodiments of the present application.
FIG. 3 is a second schematic perspective view of a photovoltaic module according to some embodiments of the present application.
FIG. 4 is a second schematic side view of a photovoltaic module according to some embodiments of the present application.
FIG. 5 is a third schematic side view of a photovoltaic module according to some embodiments of the present application.
FIG. 6 is a fourth schematic side view of a photovoltaic module according to some embodiments of the present application.
FIG. 7 is a fifth schematic side view of a photovoltaic module according to some embodiments of the present application.
FIG. 8 is a schematic top view of a photovoltaic module according to some embodiments of the present application.
FIG. 9 is a first schematic sectional view of a photovoltaic module according to some embodiments of the present application.
FIG. 10 is a second schematic sectional view of a photovoltaic module according to some embodiments of the present application.
FIG. 11 is a third schematic sectional view of a photovoltaic module according to some embodiments of the present application.
FIG. 12 is a schematic sectional view of an insulating layer of a photovoltaic module according to some embodiments of the present application.

### DETAILED DESCRIPTION

In the description of the present application, it should be understood that when the terms such as "center", "longitudinal", "transverse", "length", "width", "thickness", "upper", "lower", "front", "back", "left", "right", "vertical", "horizontal", "top", "bottom", "inside", "outside", "clockwise", "anticlockwise", "axial direction", "radial direction", and "circumferential direction" appear, orientation or position relationships indicated by these terms are based on orientation or position relationships shown in the accompanying drawings, and are intended to facilitate the description of the present application and simplify the description only, rather than indicate or imply that the mentioned apparatus or element must have a particular orientation or must be constructed and operated in a particular orientation. Therefore, such terms should not be construed as limiting the present application.

In addition, if the terms "first" and "second" appear, these terms are used merely for the purpose of description, and should not be construed as indicating or implying relative importance or implying a quantity of indicated technical features. Therefore, features defined with "first" and "second" may explicitly or implicitly include at least one of such features. In the description of the present application, if the term "a plurality of" appears, "a plurality of" means at least two, such as two or three, unless otherwise explicitly limited.

In the present application, unless otherwise explicitly specified and limited, if the terms "mount", "connect", "connection", and "fix" appear, these terms should be understood in a broad sense. For example, it may be a fixed connection, a detachable connection, or an integrated connection; it may be a mechanical connection or an electrical connection; it may be a direct connection, an indirect connection through an intermediate medium, an internal communication of two elements, or interaction between two elements, unless otherwise expressly limited. Those of ordinary skill in the art should understand specific meanings of the above-mentioned terms in the present application according to specific situations.

In the present application, unless otherwise explicitly specified and limited, if descriptions such as a first feature being "on" or "below" a second feature appear, it may mean that the first feature and the second feature are in direct contact, or that the first feature and the second feature are in indirect contact through an intermediary medium. Moreover, the first feature being "over", "above", and "on" the second feature may be the first feature being over or above the second feature, or merely means that the first feature is at a higher horizontal level than the second feature. The first feature being "under", "below", and "underneath" the second feature may be the first feature being under or below the second feature, or merely indicates that the level of the first feature is lower than that of the second feature.

It should be noted that if an element is referred to as being "fixed to" or "disposed on" another element, the element may be directly disposed on the another element or there may be a middle element. If an element is considered to be "connected to" another element, the element may be directly connected to the another element or there may be a middle element at the same time. If present, the terms "vertical", "horizontal", "upper", "lower", "left", "right", and similar expressions used in the present application are for illustrative purposes only and do not represent the only implementation.

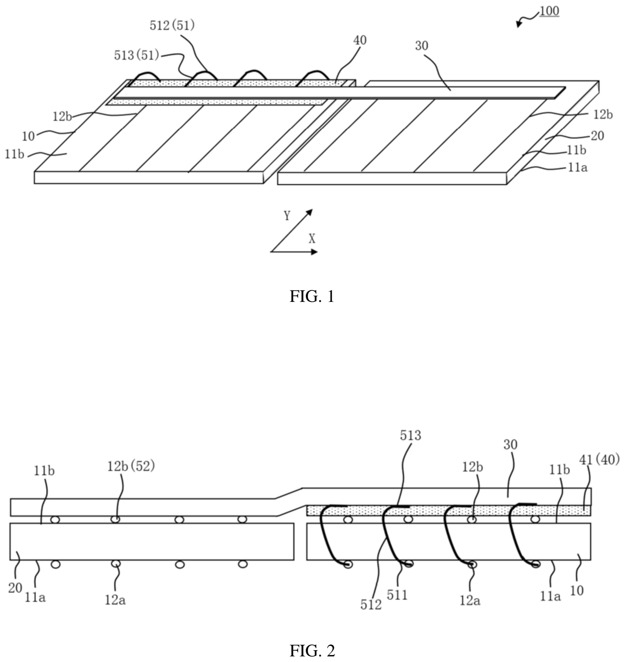

Refer is made to FIG. 1 to FIG. 8. FIG. 1 is a first schematic perspective view of a photovoltaic module according to some embodiments of the present application. FIG. 2 is a first schematic side view of a photovoltaic module according to some embodiments of the present application. FIG. 2 is a schematic side view of the photovoltaic module in FIG. 1.

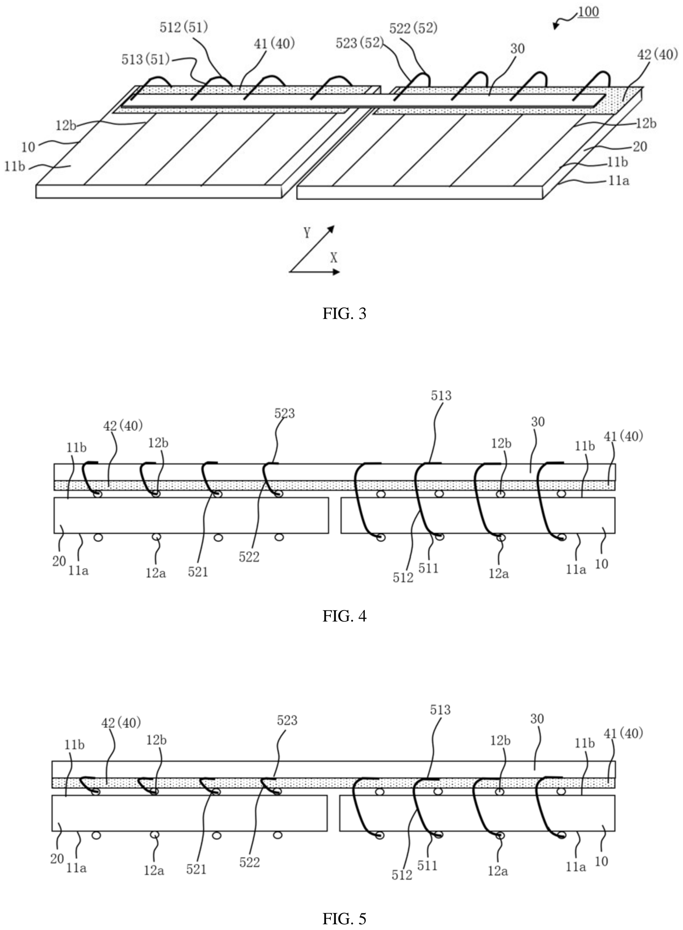

FIG. 3 is a second schematic perspective view of a photovoltaic module according to some embodiments of the present application. FIG. 4 is a second schematic side view of a photovoltaic module according to some embodiments of the present application. FIG. 4 is a schematic side view of the photovoltaic module in FIG. 3.

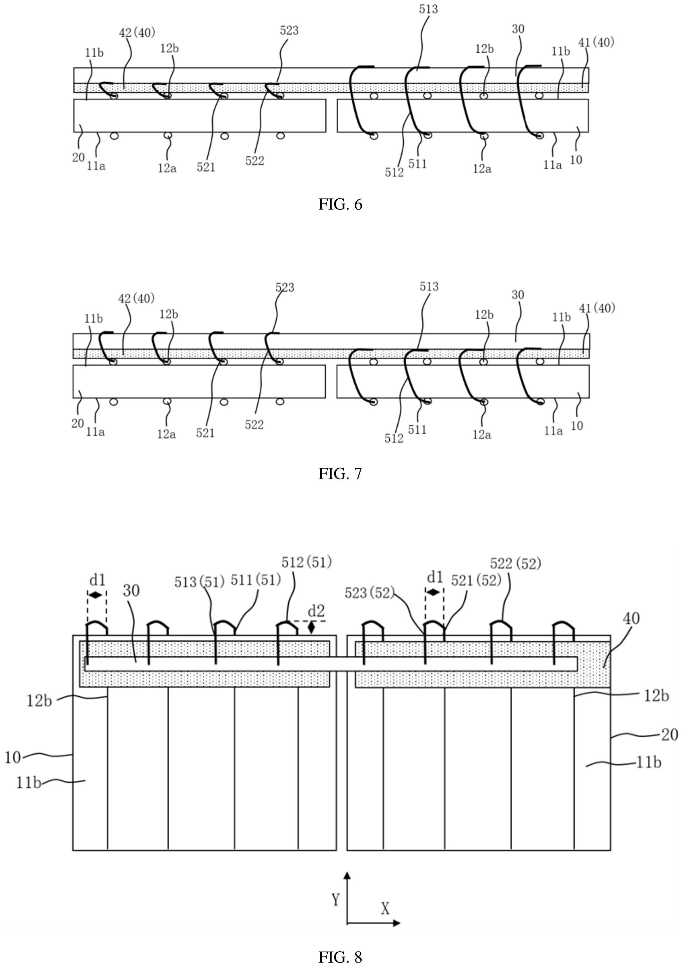

FIG. 5 is a third schematic side view of a photovoltaic module according to some embodiments of the present application. FIG. 6 is a fourth schematic side view of a photovoltaic module according to some embodiments of the present application. FIG. 7 is a fifth schematic side view of a photovoltaic module according to some embodiments of the present application.

FIG. 8 is a schematic top view of a photovoltaic module according to some embodiments of the present application. FIG. 8 is a schematic top view of the photovoltaic module in FIG. 3.

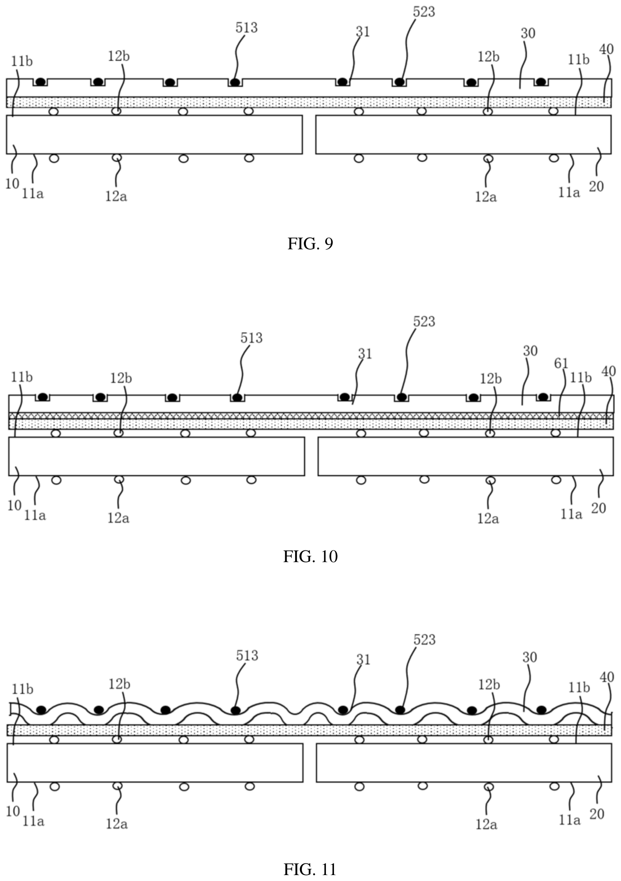

FIG. 9 is a first schematic sectional view of a photovoltaic module according to some embodiments of the present application. FIG. 10 is a second schematic sectional view of a photovoltaic module according to some embodiments of the present application. FIG. 11 is a third schematic sectional view of a photovoltaic module according to some embodiments of the present application. FIG. 9 to FIG. 11 are sectional structures of a busbar portion in FIG. 8 taken along a first direction X.

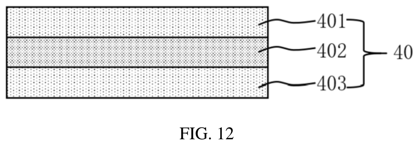

FIG. 12 is a schematic sectional view of an insulating layer of a photovoltaic module according to some embodiments of the present application.

The present application provides a photovoltaic module 100. The photovoltaic module 100 includes a first cell piece 10, a second cell piece 20, a busbar 30, an insulating layer 40, a first solder ribbon 51, and a second solder ribbon 52. The first cell piece 10 and the second cell piece 20 are arranged in a first direction X. The first cell piece 10 and the second cell piece 20 each have a front face 11a and a back face 11b opposite to each other. The first cell piece 10 and the second cell piece 20 are each provided with electrodes on the front face 11a and the back face 11b. The busbar 30 is at least partially disposed on the back faces 11b of the first cell piece 10 and the second cell piece 20. The insulating layer 40 is at least disposed between the back face 11b of the first cell piece 10 and the busbar 30. The first solder ribbon 51 is disposed to bend from the front face 11a of the first cell piece 10 to the back face 11b of the first cell piece 10, so as to be electrically connected between the electrode on the front face 11a of the first cell piece 10 and the busbar 30. The second solder ribbon 52 is electrically connected to each of the electrode on the back face 11b of the second cell piece 20 and the busbar 30.

Exemplarily, in some embodiments, the photovoltaic module 100 includes a laminate and a border frame. The laminate includes a cover plate, a first adhesive film, a plurality of cell strings, a second adhesive film, and a back plate. Each of the cell strings include a plurality of cell pieces connected in series. The cover plate, the first adhesive film, the plurality of cell strings, the second adhesive film, and the back plate are laminated to form the laminate. The laminate is assembled with the border frame to form the photovoltaic module 100. However, it should be understood that the structure of the photovoltaic module 100 is not limited thereto.

Exemplarily, in some embodiments, the first adhesive film and the second adhesive film may each independently be selected from ethylene-vinyl acetate copolymer (EVA) adhesive films, polyolefin elastomer (POE) adhesive films, polyethylene terephthalate (PET) adhesive films, polyvinyl butyral (PVB) adhesive films, EPE adhesive films (three-layer co-extruded adhesive films of EVA and POE), EP adhesive films (two-layer co-extruded adhesive films of EVA and POE), or other types of adhesive films, which may be selected according to actual needs and are not limited herein.

Exemplarily, in some embodiments, the cover plate is disposed on a side of the first adhesive film away from the cell pieces (a side of the front faces 11a away from the back faces 11b). The cover plate may be made of a transparent material such as a glass or polymer material. When the cover plate is made of a glass, the cover plate may also be referred to as "photovoltaic glass", which has excellent light transmittance and high hardness, so that after being covered on the first adhesive film, the cover plate can be adapted to significant diurnal temperature variations and harsh weather conditions to protect the cell pieces. The glass used for the cover plate may be an ultra-clear embossed photovoltaic glass, an ultra-clear processed float glass, a TCO glass, among other types of front plate glass, which may be selected according to actual needs and are not limited herein.

Exemplarily, in some embodiments, the back plate is disposed on a side of the second adhesive film away from the cell pieces (a side of the back face 11b away from the front face 11a). The back plate also provides protection and support for the cell pieces. The back plate can exhibit excellent weather resistance, water tightness, corrosion resistance, insulating property, etc. The back plate not only can isolate the photovoltaic module from surrounding photovoltaic environments, but also can effectively protect and support the cell pieces, thereby increasing the impact resistance of the photovoltaic module. The back plate may be made of a glass material (e.g., a rolled glass or an ultra-clear rolled glass), a TPT (a polyvinyl fluoride composite film), a thermoplastic elastomer (TPE), etc.

Exemplarily, the photovoltaic module 100 may include a plurality of cell strings. The first cell piece 10 and the second cell piece 20 may refer to terminal cell pieces of two adjacent cell strings, but are not limited thereto.

Exemplarily, the front faces 11a of the first cell piece 10 and the second cell piece 20 refer to the sides of the first cell piece 10 and the second cell piece 20 that receive sunlight irradiation or mainly receive sunlight irradiation.

Exemplarily, the back faces 11b of the first cell piece 10 and the second cell piece 20 refer to the sides of the first cell piece 10 and the second cell piece 20 that face away from the sunlight.

Exemplarily, the front faces 11a of the first cell piece 10 and the second cell piece 20 may each be provided with a first electrode 12a thereon. The back faces 11b of the first cell piece 10 and the second cell piece 20 may each be provided with a second electrode 12b thereon. The first electrode 12a may be one of a positive grid and a negative grid, and the second electrode 12b may be the other one of the positive grid and the negative grid.

Exemplarily, in some embodiments, the first solder ribbon 51 may be directly electrically connected to the first electrode 12a on the front face 11a of the first cell piece 10. Exemplarily, in some embodiments, the first solder ribbon 51 may be electrically connected to the first electrode 12a on the front face 11a of the first cell piece 10 through a first sub-solder ribbon. Exemplarily, in some embodiments, the first solder ribbon 51 and the first sub-solder ribbon may be separate solder ribbons. Exemplarily, in some embodiments, the first solder ribbon 51 and the first sub-solder ribbon may be integrally formed or the same solder ribbon.

Exemplarily, the photovoltaic module 100 may include a plurality of cell strings. Each of the plurality of cell strings may include a plurality of cell pieces connected in series. For example, the cell pieces connected in series within the same cell string may be connected by a solder ribbon, but is not limited thereto.

Exemplarily, the busbar 30 is disposed at least partially on the back face 11b of the cell string. In a thickness direction of the cell pieces, the busbar 30 at least partially overlaps with the cell pieces. In some embodiments, the busbar 30 is entirely disposed on the back face 11b of the cell string.

Exemplarily, compared to the related art where the busbar and the cell pieces are placed in the same plane, in the present application, disposing the busbar 30 at least partially on the back face 11b of the cell string reduces an area occupied by the busbar 30 within the photovoltaic module, and increases an area of the photovoltaic module 100 that receives the sunlight irradiation, thereby increasing an effective power generation area and improving both an area utilization rate and a module power of the photovoltaic module 100.

Exemplarily, the insulating layer 40 is disposed at least between the back face 11b of the first cell piece 10 and the busbar 30, which can prevent the short circuit between the busbar 30 and the second electrode 12b on the back face 11b of the first cell piece 10.

Exemplarily, the first solder ribbon 51 is disposed to bend from the front face 11a of the first cell piece 10 to the back face 11b of the first cell piece 10 to electrically connect the busbar 30 on the back face 11b of the first cell piece 10 and the first electrode 12a on the front face 11a of the first cell piece 10.

Exemplarily, FIG. 1 illustrates that the first direction X is perpendicular to a second direction Y, and a plane where the first direction X and the second direction Y are located is parallel to a plane where the first cell piece 10 is located.

In the embodiments of the present application, the busbar 30 is disposed at least partially on the back face 11b of the cell string. The first solder ribbon 51 is disposed to bend from the front face 11a of the first cell piece 10 to the back face 11b of the first cell piece 10, so as to be electrically connected between the electrode on the front face 11a of the first cell piece 10 and the busbar 30. Compared to the related art where the busbar 30 and the cell pieces are placed in the same plane, in the present application, disposing the busbar 30 at least partially on the back face 11b of the cell string reduces the area occupied by the busbar 30 within the photovoltaic module and increases the area of the photovoltaic module 100 that receive the sunlight irradiation, thereby increasing the effective power generation area and improving both the area utilization rate and the module power of the photovoltaic module 100.

In some embodiments, the first solder ribbon 51 includes a first connecting segment 511, a first curved segment 512, and a second connecting segment 513 which are connected sequentially. The first connecting segment 511 is disposed on a side of the front face 11a of the first cell piece 10 facing away from the back face 11b of the first cell piece 10. The second connecting segment 513 is disposed on a side of the back face 11b of the first cell piece 10 facing away from the front face 11a of the first cell piece 10. The first curved segment 512 is disposed to bend in an arc shape.

Exemplarily, the first curved segment 512 is disposed to bend in an arc shape, which not only allows the first connecting segment 511 to be electrically connected to the first electrode 12a on the front face 11a of the first cell piece 10 and allows the second connecting segment 513 to be electrically connected to the busbar 30 on the back face 11b of the first cell piece 10, but also reduces the risk of damage such as breakage of the first curved segment 512.

In some embodiments, as shown in FIG. 1 and FIG. 2, a surface of the busbar 30 proximate to the second cell piece 20 is connected to the electrode on the back face 11b of the second cell piece 20 through the second solder ribbon 52.

Exemplarily, as shown in FIG. 1 and FIG. 2, the surface of the busbar 30 proximate to the second cell piece 20 is connected to the electrode on the back face 11b of the second cell piece 20 through the second solder ribbon 52, which means that the surface of the busbar 30 proximate to the second cell piece 20 is in contact with the second solder ribbon 52, and the second solder ribbon 52 is in turn in contact with the electrode on the back face 11b of the second cell piece 20, resulting in an effect of a simplified manufacturing process. However, it should be understood there may be a portion of the electrode that do not overlap with the second solder ribbon 52, and in this case, the surface of the busbar 30 proximate to the second cell piece 20 may be in direct contact with this portion of the electrode.

It should be noted that FIG. 2 illustrates that the second connecting segment 513 is connected to the busbar 30 at a position between the insulating layer 40 and the busbar 30. Alternatively, the second connecting segment 513 may be connected to the busbar 30 at a side of the busbar 30 away from the insulating layer 40.

In some embodiments, as shown in FIG. 3 to FIG. 7, the insulating layer 40 includes a first insulating portion 41 and a second insulating portion 42. The first insulating portion 41 is disposed between the back face 11b of the first cell piece 10 and the busbar 30, while the second insulating portion 42 is disposed between the back face 11b of the second sell piece 20 and the busbar 30. The second solder ribbon 52 is disposed to bend from a side of the second insulating portion 42 proximate to the second cell piece 20 to a side of the second insulating portion 42 away from the second cell piece 20, so as to be electrically connected to each of the electrode on the back face 11b of the second cell piece 20 and the busbar 30.

Exemplarily, different from the embodiments shown in FIG. 1 and FIG. 2, in the embodiments shown in FIG. 3 to FIG. 7, the second solder ribbon 52 is also disposed to bend. Having the second solder ribbon 52 to bend from the side of the second insulating portion 42 proximate to the second cell piece 20 to the side of the second insulating portion 42 away from the second cell piece 20 can ensure that in a thickness direction perpendicular to the cell pieces, a total thickness of the photovoltaic module 100 at the first cell piece 10 and a total thickness of the photovoltaic module 100 at second cell piece 20 can be kept consistent, which allows the busbar 30 to make firmer contact with both the first solder ribbon 51 and the second solder ribbon 52, and allows the photovoltaic module 100 to maintain uniform stress when subjected to external forces, thereby reducing the risk of damage such as breakage of the cell pieces.

Exemplarily, the insulating layer 40 includes the first insulating portion 41 and the second insulating portion 42. The first insulating portion 41 is disposed between the back face 11b of the first cell piece 10 and the busbar 30. The first insulating portion 41 and the second insulating portion 42 may be separate or spaced-apart insulating film layers, or may be of an integrally formed structure or an integrated structure.

Exemplarily, the first insulating portion 41 and the second insulating portion 42 have the same thickness, so that the total thickness of the photovoltaic module 100 at the first cell piece 10 and the total thickness of the photovoltaic module 100 at second cell piece 20 can be better kept consistent, which allows the photovoltaic module 100 to maintain uniform stress when subjected to external forces, thereby reducing the risk of damage such as breakage of the cell pieces.

In some embodiments, as shown in FIG. 3 to FIG. 7, the second solder ribbon 52 includes a third connecting segment 521, a second curved segment 522, and a fourth connecting segment 523 which are sequentially connected. The third connecting segment 521 is disposed between the back face 11b of the second cell piece 20 and the second insulating portion 42. The fourth connecting segment 523 is disposed on a side of the second insulating portion 42 away from the second cell piece 20. The second curved segment 522 is disposed to bend in an arc shape. In a direction parallel to the plane where the first cell piece 10 is located, both the first curved segment 512 and the second curved segment 522 are located on the same side of the busbar 30.

Exemplarily, the third connecting segment 521 is disposed between the back face 11b of the second cell piece 20 and the second insulating portion 42, and the third connecting segment 521 may be directly electrically connected to the second electrode 12b on the back face 11b of the second cell piece 20. Exemplarily, in some embodiments, the third connecting segment 521 may be electrically connected to the second electrode 12b on the back face 11b of the second cell piece 20 through a second sub-solder ribbon. Exemplarily, in some embodiments, the second solder ribbon 52 and the second sub-solder ribbon may be separate solder ribbons. Exemplarily, in some embodiments, the second solder ribbon 52 and the second sub-solder ribbon may be integrally formed or the same solder ribbon.

Exemplarily, the fourth connecting segment 523 is disposed on a side of the second insulating portion 42 away from the second cell piece 20 and is connected to the busbar 30.

Exemplarily, in the direction parallel to the plane where the first cell piece 10 is located, both the first curved segment 512 and the second curved segment 522 are located on the same side of the busbar 30. That is, orthogonal projections of the first curved segment 512 and the second curved segment 522 onto the plane where the first cell piece 10 is located are located on the same side of an orthogonal projection of the busbar 30 onto the plane where the first cell piece 10 is located, which can reduce the manufacturing difficulty. For example, the first solder ribbon 51 and the second solder ribbon 52 may bend towards the same direction in the same bending process.

In some embodiments, as shown in FIG. 3, FIG. 4, and FIG. 5, in a direction parallel to the thickness direction of the first cell piece 10, the second connecting segment 513 and the fourth connecting segment 523 are disposed on the same side of the busbar 30.

Exemplarily, in the direction parallel to the thickness direction of the first cell piece 10, the second connecting segment 513 and the fourth connecting segment 523 are disposed on the same side of the busbar 30, and are connected or welded to the busbar 30 at the same side of the busbar 30, without the need for connections or welds on two sides of the busbar, thereby simplifying the manufacturing process.

In some embodiments, as shown in FIG. 3 and FIG. 4, the second connecting segment 513 is disposed on a side of the busbar 30 facing away from the first insulating portion 41, while the fourth connecting segment 523 is disposed on a side of the busbar 30 facing away from the second insulating portion 42.

Exemplarily, as shown in FIG. 3 and FIG. 4, both the second connecting segment 513 and the fourth connecting segment 523 are connected to the busbar 30 at the side of the busbar 30 away from the insulating layer 40.

In some embodiments, as shown in FIG. 5, the second connecting segment 513 is disposed between the busbar 30 and the first insulating portion 41, and the fourth connecting segment 523 is disposed between the busbar 30 and the second insulating portion 42.

Exemplarily, as shown in FIG. 5, both the second connecting segment 513 and the fourth connecting segment 523 are connected to the busbar 30 at positions between the busbar 30 and the insulating layer 40.

In some embodiments, as shown in FIG. 6 and FIG. 7, and with reference also to FIG. 3, in the direction parallel to the thickness direction of the first cell piece 10, the second connecting segment 513 and the fourth connecting segment 523 are disposed on different sides of the busbar 30.

Exemplarily, in the direction parallel to the thickness direction of the first cell piece 10, the second connecting segment 513 and the fourth connecting segment 523 are disposed on different sides of the busbar 30, and are connected or welded to the busbar 30 at the two sides of the busbar 30 respectively. The first solder ribbon 51 and the second solder ribbon 52 may fix the busbar 30 respectively at the two sides of the busbar 30, so that the busbar 30 is less prone to detachment, enhancing the reliability and mechanical property of the photovoltaic module 100.

In some embodiments, as shown in FIG. 6, the second connecting segment 513 is disposed on the side of the busbar 30 away from the first insulating portion 41, and the fourth connecting segment 523 is disposed between the busbar 30 and the second insulating portion 42.

Exemplarily, as shown in FIG. 6, the second connecting segment 513 is connected to the busbar 30 at the side of the busbar 30 away from the first insulating portion 41, and the fourth connecting segment 523 is connected to the busbar 30 at a position between the busbar 30 and the second insulating portion 42.

In some embodiments, as shown in FIG. 7, the second connecting segment 513 is disposed between the busbar 30 and the first insulating portion 41, and the fourth connecting segment 523 is disposed on the side of the busbar 30 away from the second insulating portion 42.

Exemplarily, as shown in FIG. 7, the second connecting segment 513 is connected to the busbar 30 at a position between the busbar 30 and the first insulating portion 41, and the fourth connecting segment 523 is connected to the busbar 30 at the side of the busbar 30 away from the second insulating portion 42.

In some embodiments, as shown in FIG. 8, and with reference also to FIG. 3, the first connecting segment 511 and the second connecting segment 513 are spaced apart in the first direction X, with a spacing between the first connecting segment 511 and the second connecting segment 513 in the first direction X ranging from 0.5 millimeters to 3 millimeters.

Exemplarily, as shown in FIG. 8, the first connecting segment 511 and the second connecting segment 513 are spaced apart in the first direction X. That is, orthogonal projections of the first connecting segment 511 and the second connecting segment 513 onto the plane where the first cell piece 10 is located are spaced apart, so that the first curved segment 512 has a certain length in the first direction X, which reduces the thickness of the photovoltaic module 100 at this region, thereby reducing the risk of breakage of the first curved segment 512, and reducing the risk of microcracks in the cell pieces.

Exemplarily, as shown in FIG. 8, the spacing between the first connecting segment 511 and the second connecting segment 513 in the first direction X ranges from 0.5 millimeters to 3 millimeters. That is, a distance between the orthogonal projections of the first connecting segment 511 and the second connecting segment 513 onto the plane where the first cell piece 10 is located ranges from 0.5 millimeters to 3 millimeters, as indicated by a first distance d1 in FIG. 8.

Exemplarily, the first distance d1 may be any value selected from 0.5 millimeters, 1 millimeter, 1.5 millimeters, 2 millimeters, 2.5 millimeters, and 3 millimeters.

Exemplarily, in some embodiments, the third connecting segment 521 and the fourth connecting segment 523 are spaced apart in the first direction X, with a spacing between the third connecting segment 521 and the fourth connecting segment 523 in the first direction X ranging from 0.5 millimeters to 3 millimeters.

In some embodiments, as shown in FIG. 8, the first curved segment 512 is spaced apart from a side edge of the first cell piece 10 in the second direction Y, with a spacing between the first curved segment 512 and the side edge of the first cell piece 10 in the second direction Y ranging from 0.3 millimeters to 2 millimeters.

Exemplarily, as shown in FIG. 8, the first curved segment 512 is spaced apart from the side edge of the first cell piece 10 in the second direction Y, with the spacing between the first curved segment 512 and the side edge of the first cell piece 10 in the second direction Y ranging from 0.3 millimeters to 2 millimeters. That is, the orthogonal projection of the first curved segment 512 onto the plane where the first cell piece 10 is located is spaced apart from the side edge of the first cell piece 10, with a spacing between the orthogonal projection of the first curved segment 512 onto the plane where the first cell piece 10 is located and the side edge of the first cell piece 10 ranging from 0.3 millimeters to 2 millimeters, as indicated by a second distance d2 in FIG. 8, so that the short circuit between the first solder ribbon 51 and structures on the first cell piece 10 that do not require connection can be prevented, and when subjected to external forces, there is a buffer space for the first curved segment 512, thereby reducing the risk such as breakage of the first cell piece 10.

Exemplarily, as shown in FIG. 8, in some embodiments, the second curved segment 522 is spaced apart from the side edge of the second cell piece 20 in the second direction Y, with the spacing between the second curved segment 522 and the side edge of the second cell piece 20 in the second direction Y ranging from 0.3 millimeters to 2 millimeters. That is, the orthogonal projection of the second curved segment 522 onto the plane where the second cell piece 20 is located is spaced apart from the side edge of the second cell piece 20, with a spacing between the orthogonal projection of the second curved segment 522 onto the plane where the second cell piece 20 is located and the side edge of the second cell piece 20 ranging from 0.3 millimeters to 2 millimeters, as indicated by a second distance d2 in FIG. 8, so that the short circuit between the second solder ribbon 52 and structures on the second cell piece 20 that do not require connection can be prevented, and when subjected to external forces, there is a buffer space for the second curved segment 522, thereby reducing the risk such as breakage of the second cell piece 20.

Exemplarily, the second distance d2 may be any value of 0.3 millimeters, 0.5 millimeters, 0.8 millimeters, 1 millimeter, 1.2 millimeters, 1.5 millimeters, 1.8 millimeters, and 2 millimeters.

Exemplarily, in some embodiments, as shown in FIG. 9 to FIG. 11, a plurality of grooves 31 are provided on a surface of the busbar 30 proximate to the first solder ribbon 51 and/or second solder ribbon 52 adjacent thereto. The first solder ribbon 51 and/or the second solder ribbon 52 is at least partially accommodated within the corresponding groove 31, thereby allowing the busbar 30 to have a function of fixing the first solder ribbon 51 and/or the second solder ribbon 52, or allowing the first solder ribbon 51 and/or the second solder ribbon 52 to have a function of fixing the busbar 30, and thus improving the reliability and mechanical property of the photovoltaic module 100.

Exemplarily, in some embodiments, as shown in FIG. 11, the busbar 30 may be in a wavy shape, with the grooves 31 being defined by troughs of the wavy shape.

Exemplarily, in some embodiments, as shown in FIG. 10, when no solder ribbon connection is provided between the busbar 30 and the insulating layer 40, an adhesive layer 61 may be disposed between the busbar 30 and the insulating layer 40. The adhesive layer 61 bonds the busbar 30 to the insulating layer 40, thereby improving reliability and mechanical strength, avoiding misalignment or other displacement of the insulating layer 40, and enhancing the reliability and mechanical property of the photovoltaic module 100. Exemplarily, the adhesive layer 61 may be disposed between the busbar 30 and the insulating layer 40 in the embodiment shown in FIG. 4, between the busbar 30 and the first insulating portion 41 in the example shown in FIG. 6, or between the busbar 30 and the second insulating portion 42 in the example shown in FIG. 7.

It should be noted that, as shown in FIG. 12, the insulating layer 40 may include a first sub-insulating film 401, a second sub-insulating film 402, and a third sub-insulating film 403 which are stacked. The first sub-insulating film 401 and the third sub-insulating film 403 are made of elastomeric materials. Exemplarily, the second sub-insulating film 402 is sandwiched between the first sub-insulating film 401 and the third sub-insulating film 403. Exemplarily, the second sub-insulating film 402 may be made of a non-elastomeric material to provide insulation and support. Exemplarily, the first sub-insulating film 401 and the third sub-insulating film 403 are made of the elastomeric materials, thereby achieving a buffer function. For example, when the busbar 30 is subjected to external impacts, the first sub-insulating film 401 and the third sub-insulating film 403 may buffer external stress, thereby preventing damage to the cell pieces.

It should be noted that, in some embodiments, with reference to FIG. 8, the insulating layer 40 may extend on the back face 11b into a spacing between the second solder ribbon 52 and a side edge of the second cell piece 20 away from the first cell piece 10 in the first direction X, and the insulating layer 40 may extend on the back face 11b into a spacing between the first solder ribbon 51 and a side edge of the first cell piece 10 away from the second cell piece 20 in the first direction X, thereby buffering the external impacts and protecting edges of the cell pieces.

## Claims

1. A photovoltaic module, comprising:
a first cell piece and a second cell piece arranged in a first direction, the first cell piece and the second cell piece each having a front face and a back face opposite to each other, and the front face and the back face of each of the first cell piece and the second cell piece being each provided with an electrode thereon;
a busbar at least partially disposed on the back faces of the first cell piece and the second cell piece;
an insulating layer disposed at least between the back face of the first cell piece and the busbar; and
a first solder ribbon and a second solder ribbon;
wherein the first solder ribbon is disposed to bend from the front face of the first cell piece to the back face of the first cell piece, so as to be electrically connected between the electrode on the front face of the first cell piece and the busbar; and
the second solder ribbon is separately electrically connected to the electrode on the back face of the second cell piece and the busbar.

2. The photovoltaic module according to claim 1, wherein the first solder ribbon comprises a first connecting segment, a first curved segment, and a second connecting segment which are connected sequentially; the first connecting segment is disposed on a side of the front face of the first cell piece facing away from the back face of the first cell piece; the second connecting segment is disposed on a side of the back face of the first cell piece facing away from the front face of the first cell piece, and the first curved segment is disposed to bend in an arc shape.

3. The photovoltaic module according to claim 2, wherein a surface of the busbar proximate to the second cell piece is connected to the electrode on the back face of the second cell piece through the second solder ribbon.

4. The photovoltaic module according to claim 2 or 3, wherein the insulating layer comprises a first insulating portion and a second insulating portion; the first insulating portion is disposed between the back face of the first cell piece and the busbar; and the second insulating portion is disposed between the back face of the second sell piece and the busbar; and
the second solder ribbon is disposed to bend from a side of the second insulating portion proximate to the second cell piece to a side of the second insulating portion away from the second cell piece, so as to be electrically connected to each of the electrode on the back face of the second cell piece and the busbar.

5. The photovoltaic module according to claim 4, wherein the second solder ribbon comprises a third connecting segment, a second curved segment, and a fourth connecting segment which are sequentially connected; the third connecting segment is disposed between the back face of the second cell piece and the second insulating portion; the fourth connecting segment is disposed on the side of the second insulating portion away from the second cell piece; and the second curved segment is disposed to bend in an arc shape; and
the first curved segment and the second curved segment are located on the same side of the busbar in a direction parallel to a plane where the first cell piece is located.

6. The photovoltaic module according to claim 5, wherein the second connecting segment and the fourth connecting segment are disposed on the same side of the busbar in a direction parallel to a thickness direction of the first cell piece.

7. The photovoltaic module according to claim 6, wherein the second connecting segment is disposed on a side of the busbar facing away from the first insulating portion, and the fourth connecting segment is disposed on a side of the busbar facing away from the second insulating portion; or
the second connecting segment is disposed between the busbar and the first insulating portion, and the fourth connecting segment is disposed between the busbar and the second insulating portion.

8. The photovoltaic module according to claim 5, wherein the second connecting segment and the fourth connecting segment are disposed on different sides of the busbar in a direction parallel to a thickness direction of the first cell piece.

9. The photovoltaic module according to claim 8, wherein the second connecting segment is disposed on a side of the busbar facing away from the first insulating portion, and the fourth connecting segment is disposed between the busbar and the second insulating portion; or
the second connecting segment is disposed between the busbar and the first insulating portion, and the fourth connecting segment is disposed on a side of the busbar facing away from the second insulating portion.

10. The photovoltaic module according to any one of claims 2 to 9, wherein the first connecting segment and the second connecting segment are spaced apart in the first direction, with a spacing between the first connecting segment and the second connecting segment in the first direction ranging from 0.5 millimeters to 3 millimeters; and/or,
the first curved segment is spaced apart from a side edge of the first cell piece in a second direction perpendicular to the first direction and parallel to a plane where the first cell piece is located, with a spacing between the first curved segment and the side edge of the first cell piece in the second direction ranging from 0.3 millimeters to 2 millimeters.

11. The photovoltaic module according to any one of claims 5 to 8, wherein the third connecting segment and the fourth connecting segment are spaced apart in the first direction, with a spacing between the third connecting segment and the fourth connecting segment in the first direction ranging from 0.5 millimeters to 3 millimeters; and/or
the second curved segment is spaced apart from a side edge of the second cell piece in a second direction perpendicular to the first direction and parallel to a plane where the second cell piece is located, with a spacing between the second curved segment and the side edge of the second cell piece in the second direction ranging from 0.3 millimeters to 2 millimeters.

12. The photovoltaic module according to any one of claims 1 to 11, wherein the photovoltaic module comprises a plurality of cell strings, each of the plurality of cell strings comprises a plurality of cell pieces, and the first cell piece and the second cell piece are respectively terminal cell pieces of adjacent two of the plurality of cell strings.

13. The photovoltaic module according to any one of claims 1 to 12, wherein a plurality of grooves are provided on a surface of the busbar proximate to the first solder ribbon or second solder ribbon adjacent thereto, and the first solder ribbon or the second solder ribbon is at least partially accommodated within corresponding one of the plurality of grooves;
optionally, the busbar is in a wavy shape, with the plurality of grooves being defined by a plurality of troughs of the wavy shape.

14. The photovoltaic module according to any one of claims 1 to 13, wherein the insulating layer comprises a first sub-insulating film, a second sub-insulating film, and a third sub-insulating film which are stacked in sequence; and the first sub-insulating film and the third sub-insulating film are made of elastomeric materials;
optionally, the second sub-insulating film is made of a non-elastomeric material.

15. The photovoltaic module according to any one of claims 1 to 14, wherein a total thickness of the photovoltaic module at the first cell piece and a total thickness of the photovoltaic module at second cell piece are kept consistent.
